# EUROPEAN PATENT APPLICATION

(11) **EP 0 657 553 A1**
(43) Date of publication of application: **14.06.1995**
(21) Application number: 94117382.5
(22) Date of filing: 03.11.1994
(51) Int. Cl.: C22C 1/04, C22C 1/10, C22C 21/04, C22C 45/08

(54) **Nitrogenous aluminum-silicon powder metallurgical alloy**

(30) Priority: 10.11.1993 JP 281401/93; 01.09.1994 JP 208667/94; 27.09.1994 JP 258704/94
(71) Applicant: Sumitomo Electric Industries, Ltd., Osaka 541 (JP)
(72) Inventor: Yamagata, Shin-ichi, c/o Itami Works of Sumitomo, Itami-shi, Hyogo (JP); Takano, Yoshishige, c/o Itami Works of Sumitomo, Itami-shi, Hyogo (JP); Hayashi, Tetsuya, c/o Itami Works of Sumitomo, Itami-shi, Hyogo (JP); Abe, Yugaku, c/o Itami Works of Sumitomo, Itami-shi, Hyogo (JP)
(74) Representative: Herrmann-Trentepohl, Werner, Dipl.-Ing.

(57) **Abstract**

A nitrogenous Al-Si powder metallurgical alloy contains at least 4wt% and at most 15wt% of nitrogen, a least 8.5wt% and at most 48wt% of silicon, at most 9.6wt% of at least one element selected from the group consisting of Li, Mg, Ti, V, Cr, Mn, Fe, Co, Ni, Cu, Zn, Zr, Nb, Mo and W, with the remaining part consisting essentially of Al. Consequently, a highly safe material which is light and having the density of at most 3.0g/cm³, thermal expansion coefficient of from 5 to 10x10⁻⁶/°C and thermal conductivity coefficient of at least 0.2cal/cm·sec·°C can be obtained.

## Description

### BACKGROUND OF THE INVENTION

### Field of the Invention

The present invention relates to nitrogenous aluminum-silicon powder metallurgical alloy and manufacturing method thereof. More particularly, the present invention relates to nitrogenous aluminum-silicon powder metallurgical alloy and manufacturing method thereof used for a heat sink or the like, which is one of the material constituting a semiconductor device.

### Description of the Background Art

In a material constituting a substrate for a semiconductor device, strain must not be generated by thermal stress. Therefore, the material constituting the substrate for a semiconductor device must have a coefficient of thermal expansion not much different from that of the semiconductor element or that of a material to be combined. More specifically, it is required that the material has coefficient of thermal expansion close to the coefficient of thermal expansion of the Si (silicon) or GaAs (gallium arsenic) semiconductor, and between the coefficient of thermal expansion of the semiconductor and that of Aℓ (aluminum) or Cu (copper) used as a heat radiator.

Recently, scale and degree of integration of the devices have been increased. Therefore, the material constituting a semiconductor substrate is further required to have a high coefficient of thermal conductivity, in terms of heat sink function for effectively remove thermal energy from the semiconductor device.

In view of the foregoing, a material having coefficient of thermal conductivity of at least 0.2cal/cm·sec·°C and coefficient of thermal expansion in the range of 5 x 10⁻⁶ to 10 x 10⁻⁶/°C has been in greater demand.

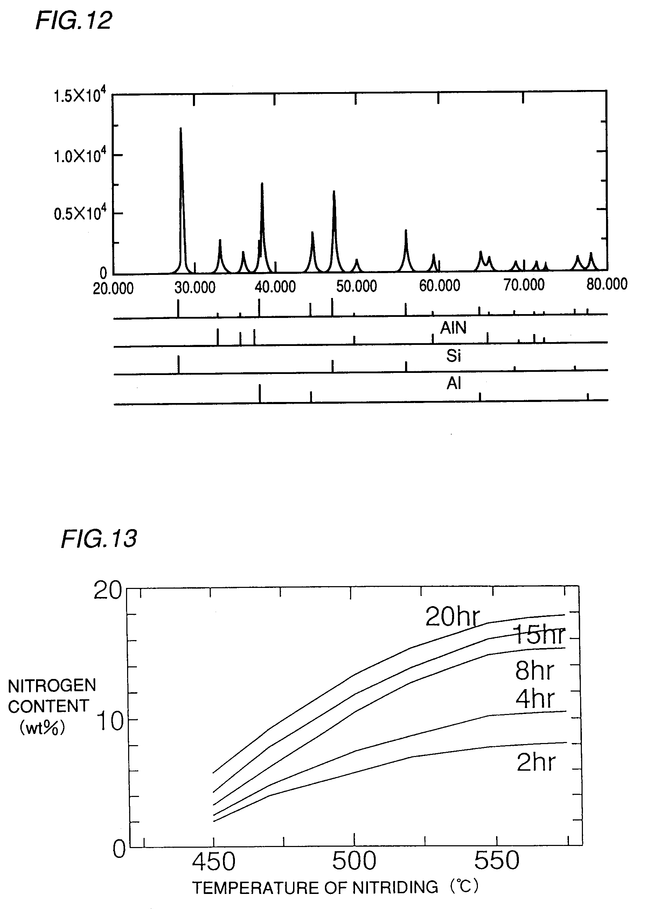

Under these circumstances, materials satisfying the aforementioned conditions include BeO, AℓN, Cu-Mo alloy and Cu-W alloy, as shown in Fig. 11. A composite material including SiC porous structure impregnating Aℓ or Aℓ-Si alloy satisfies these properties, and therefore application of this composite material to such application has been studied. The composite material is, more specifically, an SiC porous structure of 50 to 72 volume %, with 14 to 30 volume % of Aℓ₂O₃ and 9 to 20 volume % of Ni-Si-Aℓ alloy or Aℓ-Si alloy being impregnated thereinto.

Recently, reduction in weight of various industrial equipments and particularly aerospace and aircraft equipments has been strongly desired, and therefore reduction in weight of a heat sink is also desired. However, BeO, AℓN, Cu-Mo alloy, Cu-W alloy or the aforementioned composite material which are listed as materials satisfying the above described properties (heat conductivity, coefficient of thermal expansion) have their field of application limited because of the following practical disadvantages.

First, though Cu-Mo alloy and Cu-W alloy have superior heat conductivity, they have relatively high specific gravity of 9 to 17g/cm³. Though BeO has a small density as 2.9g/cm³, it cannot be used at present in view of safety and environmental pollution, since it is highly toxic. Though AℓN has relatively small density of 3.3g/cm³, machining is difficult, since it is ceramics.

The composite material having SiC porous structure with Aℓ or Aℓ-Si alloy impregnated therein satisfies the above described condition as it has the coefficient of thermal expansion from 5 x 10⁻⁶ to 8 x 10⁻⁶/°C, and in addition, it has relatively small density of 3.3g/cm³. However, this composite material contains no less than 50 volume % of SiC which is hard ceramics. Therefore, cutting of this composite material is extremely difficult. Further, there are a number of restrictions in manufacturing and in the shapes of products, and therefore the composite material has been not widely used in practice.

As described above, conventionally, a material having the density of at most 3.0g/cm³, coefficient of thermal expansion of 5 x 10⁻⁶ to 10 x 10⁻⁶/°C and coefficient of thermal conductivity of at least 0.2cal/cm·sec·°C, and satisfy safety and environmental conditions has never been obtained.

Accordingly, when a conventional material is used for a heat sink, at least one of the above described conditions (density, coefficient of thermal conductivity, coefficient of thermal expansion, safety) cannot be satisfied. This results in cracks or peeling because of the difference in coefficients of thermal expansion of the heat sink and the material of the counterpart, insufficient radiation because of low coefficient of thermal conductivity, hindrance to reduction in weight because of high density, and so on.

Further, a method of manufacturing the material satisfying the above described conditions in a short period of time at low temperature has not been provided.

### SUMMARY OF THE INVENTION

An object of the present invention is to provide a material satisfying the conditions that it has the density of at most 3.0g/cm³, coefficient of thermal expansion in the range from 5 x 10⁻⁶ to 10 x 10⁻⁶/°C and coefficient of thermal conductivity of at least 0.2cal/cm·sec·°C, and which is superior in safety.

Another object of the present invention is to provide a method of manufacturing the material having the above described properties in a short period of time at a low temperature.

### [Nitrogen Content]

As a result of intensive study for attaining the above described objects, the inventors have found that a nitrogenous aluminum-silicon powder alloy containing at least 4 and at most 15 wt% of nitrogen and the remaining part consisting substantially of Aℓ, Si and unavoidable component satisfies the properties that it has the density of at most 3.0g/cm³, coefficient of thermal expansion in the range of 5 x 10⁻⁶ to 10 x 10⁻⁶/°C and coefficient of thermal conductivity of at least 0.2cal/cm·sec·°C, and that it has superior safety.

Accordingly, the nitrogenous Aℓ-Si powder metallurgical alloy in accordance with a first aspect of the present invention contains 4 to 15 wt% of nitrogen and its remaining part consists substantially of Aℓ, Si and an unavoidable component.

Further, as a result of intensive study, the inventors have found that a nitrogenous Aℓ-Si powder metallurgical alloy containing 4 to 15 wt% of nitrogen, 8.5 to 48 wt% of Si and at most 9.6 wt% of a prescribed element added, remaining part of which substantially consists of Aℓ and an unavoidable component, has the density of at most 3.0g/cm³, coefficient of thermal expansion in the range of 5 x 10⁻⁶ to 10 x 10⁻⁶/cm°C, coefficient of thermal conductivity of at least 0.2cal/cm·sec·°C and superior safety.

Accordingly, the nitrogenous Aℓ-Si powder metallurgical alloy in accordance with another aspect of the present invention contains 4 to 15 wt% of nitrogen, 8.5 to 48 wt% of Si, at most 9.6 wt% of at least one element selected from the group consisting of Li (lithium), Mg (magnesium), Ti (titanium), V (vanadium), Cr (chrome), Mn (manganese), Fe (iron), Co (cobalt), Ni (nickel), Cu (copper), Zn (zinc), Zr (zirconium), Nb (niobium), Mo (molybdenum) and W (tungsten), and remaining part of which substantially consists of Aℓ and an unavoidable component.

In the nitrogenous Aℓ-Si powder metallurgical alloy in accordance with the above described two aspects of the present invention, content of nitrogen is very important. If the content of nitrogen is smaller than 4 wt%, the coefficient of thermal expansion exceeds 10 x 10⁻⁶/°C. This results in cracks or peeling due to the difference in coefficient of thermal expansion of the semiconductor device. If the content of nitrogen exceeds 15 wt%, the coefficient of thermal conductivity becomes smaller than 0.2cal/cm·sec·°C. Therefore, heat radiation decreases, and the function as a heat sink is degraded.

### [Form of Nitride]

Nitrogen included in nitrogenous Aℓ-Si powder metallurgical alloy forms nitrogenous substance and preferably, at least 90 wt% of the nitride consists of AℓN.

At a surface of a rapidly solidified Aℓ-Si alloyed powder, nitride is generated by the reaction between the nitrogen in the atmosphere and the Aℓ-Si alloyed powder during nitriding. This reaction starts from the surface of an Aℓ matrix portion of Aℓ-Si alloyed powder and nitride is generated on the surface of original powder interface or original powder surface. The nitride generated on the original powder interface or original powder surface is AℓN.

AℓN has the density of 3.3g/cm³, coefficient of thermal expansion of 4.5 x 10⁻⁶/°C, and relatively high coefficient of thermal conductivity, though it depends on concentration of an impurity such as oxygen and on whether there is crystal lattice strain. Therefore, target properties can be attained by controlling the amount of AℓN to be generated. For this purpose, it is necessary that the nitrogen reacts with the Aℓ component to form AℓN. When controllability is taken into account, preferably 90wt% of nitrogen should be in the form of AℓN.

As already described, since nitrogen content is from 4wt% to 15wt% in the present invention, the amount of AℓN in the nitrogenous Aℓ-Si powder metallurgical alloy corresponds to 10wt% to 45wt%.

AℓN which is a nitrogenous substance in the nitrogenous Aℓ-Si powder metallurgical alloy is not obtained by mixing AℓN particles in Aℓ-Si alloyed powder, but by a reaction of Aℓ-Si alloyed powder in nitrogen. Therefore, as compared with the case in which AℓN powder is mixed, AℓN in the present invention well adheres to Aℓ matrix. This facilitates flow of particles when heated, enabling manufacture of homogenous products even when the products have complicated shapes, through hot consolidating such as forging or extrusion. Further, AℓN is very fine and dispersed densely in the present invention. Therefore, the nitrogenous Aℓ-Si powder metallurgical alloy of the present invention has superior machinability and high mechanical strength. Since AℓN is generated to coat Aℓ having low melting point, the nitrogenous Aℓ-Si powder metallurgical alloy of the present invention also has superior heat resistance.

Though commercially available AℓN is expensive, Aℓ is directly nitrided in the present invention, and therefore the nitrogenous Aℓ-Si powder metallurgical alloy of the present invention is superior from the view of manufacturing cost.

### [Influence of Added Element]

In the method of manufacturing the nitrogenous Aℓ-Si powder metallurgical alloy of the present invention, in addition to Si, at least one element selected from the group consisting of Li, Mg, Ti, V, Cr, Mn, Fe, Co, Ni, Cu, Zn, Zr, Nb, Mo and W is added to molten Aℓ alloy.

Addition of such element has an effect of accelerating nitriding reaction. The reason has not been clarified. However, possible reason is that such element as Li or Mg which are highly susceptible to oxidation reduces the oxide film at the surface of Aℓ. Further, since an element having different coefficient of thermal expansion is added, uneven expansion occurs in the powder, promoting diffusion of nitrogen into the powder. When added, Fe or Ni forms a compound by the reaction with Aℓ, which compound hinders movement of Si particles when heated. Therefore, it can suppress grain growth of Si crystal crystallized or precipitated in Aℓ matrix during nitriding reaction.

Since an element promoting nitriding reaction is added to the alloy metallurgical powder, a nitrogenous Aℓ-Si powder alloy having desired properties can be obtained by performing nitriding process on a molded body at a relatively low temperature for relatively short period of time.

However, if such an element is added to be more than 10wt% to the molten Aℓ alloy, desired property values (density, coefficient of thermal expansion, coefficient of thermal conductivity) cannot be obtained. Therefore, the amount of addition of such element to the molten Aℓ alloy must be at most 10wt%.

Since the amount of addition of the aforementioned element to the molten Aℓ alloy is at most 10wt%, the content of the added element in the nitrogenous Aℓ-Si powder metallurgical alloy after nitridation approximately corresponds to at most 9.6wt%.

### [Temperature and Time of Nitriding]

As a result of intensive study for achieving the above described objects, the inventors have found that the nitrogenous Aℓ-Si powder metallurgical alloy having the above described properties can be obtained by sintering a molded body of rapidly solidified Aℓ-Si alloyed powder together with nitrogen for 2 to 20 hours in the temperature range of 530°C to 570°C.

Accordingly, the method of manufacturing the nitrogenous Aℓ-Si powder metallurgical alloy in accordance with one aspect of the present invention includes the following steps.

At first, molten Aℓ alloy containing Si is solidified to form rapidly solidified Aℓ-Si alloyed powder. The rapidly solidified Aℓ-Si alloyed powder is subjected to compression molding, and thus a molded body is obtained. In an atmosphere containing nitrogen, the molded body is sintered for 2 to 20 hours in a temperature range of 530°C to 570°C.

In the method of manufacturing nitrogenous Aℓ-Si powder metallurgical alloy of the present invention, the temperature and time of nitriding are very important. If the temperature of nitriding is lower then 530°C, the amount of reaction of Aℓ-Si alloyed powder with the nitrogen in the atmosphere is too small, and nitriding phenomenon is not sufficiently promoted. If the temperature of nitriding exceeds 570°C, the temperature draws near to the eutectic point of Aℓ-Si, which is 578°C, resulting in softening or deformation of the alloy and enlargement of texture. Therefore, in order to sufficiently promote nitriding while suppressing enlargement of texture, the temperature for nitriding must be at least 530°C and at most 570°C.

When the temperature for nitriding is set in the range of 530°C to 570°C as mentioned above, the time for nitriding must be at least 2 hours to at most 20 hours. More specifically, when nitriding is performed at 530°C and the time for nitriding is shorter than 2 hours, the nitrogenous Aℓ-Si powder metallurgical alloy containing 4wt% of nitrogen cannot be obtained. If the temperature of nitriding is 570°C and the time for nitriding exceeds 20 hours, the nitrogenous Aℓ-Si powder metallurgical alloy containing at most 15wt% of nitrogen cannot be obtained.

It goes without saying that desired content of nitrogen (4wt% to 15wt%) can be obtained by performing nitriding for more than 20 hours at the temperature of 530°C. Similarly, the desired content of nitrogen can be obtained by nitriding for less than 2 hours at the temperature of 570°C. By appropriately controlling the temperature and time of nitriding, a nitrogenous Aℓ-Si powder metallurgical alloy having desired properties can be obtained.

Further, as a result of intensive study, the inventors have found that the nitrogenous Aℓ-Si powder metallurgical alloy having the above described properties can be manufactured through sintering in an atmosphere containing nitrogen at a relatively low temperature for a short period of time, by sintering in an atmosphere containing nitrogen a molded body Aℓ-Si alloyed powder which is rapidly solidified with a desired amount of prescribed element added thereto.

Accordingly, the method of manufacturing the nitrogenous Aℓ-Si powder metallurgical alloy of the present invention includes the following steps.

At first, a molten Aℓ alloy containing Si and at least one element selected from the group consisting of Li, Mg, Ti, V, Cr, Mn, Fe, Co, Ni, Cu, Zn, Zr, Nb, Mo and W is solidified to form a rapidly solidified Aℓ-Si alloyed powder. The rapidly solidified Aℓ-Si alloyed powder is subjected to compression molding, and thus a molded body is obtained. In an atmosphere containing nitrogen, the molded body is sintered in a temperature range of from 475°C to 570°C for 2 to 8 hours.

In the step of sintering the molded body, it is preferred that the molded body is sintered in a temperature range of from 475°C to 570°C for at least 2 hours and at most 20 hours.

Further, the molten Aℓ alloy should preferably be prepared to contain at most 10wt% of at least one element selected from the group consisting of Li, Mg, Ti, V, Cr, Mn, Fe, Co, Ni, Cu, Zn, Zr, Nb, Mo and W added thereto.

In the step of manufacturing the nitrogenous Aℓ-Si powder metallurgical alloy, the temperature and time of nitriding are very important. Since the aforementioned element is added, the temperature for nitriding can be made relatively low. However, if the temperature of nitriding is lower than 475°C, the amount of reaction of Aℓ-Si alloyed powder and nitrogen in the atmosphere is not sufficient, and nitriding phenomenon does not proceed sufficiently.

By contrast, if the temperature of nitriding exceeds 570°C, it becomes close to the eutectic point of Aℓ-Si, which is 578°C, resulting in softening, deformation of alloy and enlarging of texture. Therefore, in order to sufficiently promote nitriding while suppressing enlargement of texture, the temperature for nitriding must be at least 475°C and at most 570°C.

The temperature of starting nitriding changes dependent on the composition of the alloy.

The temperature of nitriding is set to be at least 475°C and at most 570°C, the time for nitriding must be at least 2 hours and at most 8 hours. Namely, when nitriding is to be performed at 475°C, and the time for nitriding is shorter than 2 hours, the nitrogenous Aℓ-Si powder metallurgical alloy containing 4wt% of nitrogen cannot be obtained. If the temperature of nitriding is 570°C and the time for nitriding exceeds 8 hours, the nitrogenous Aℓ-Si powder metallurgical alloy containing at most 15wt% of nitrogen cannot be obtained.

It goes without saying that the desired nitrogen content can be obtained by nitriding for more than 8 hours at the temperature of 475°C. Similarly, the desired nitrogen content can be attained by less than 2 hours at 570°C. However, if the nitriding continues for more than 20 hours at 475°C, the prescribed nitrogen content cannot be obtained. In this manner, by appropriately controlling the time and temperature of nitriding, the nitrogenous Aℓ-Si powder metallurgical alloy having desired properties can be obtained.

### [Amount of Si of Atomization Powder and Solidifying Rate]

The molten Aℓ alloy should preferably be prepared to contain at least 10wt% and at most 50wt% of Si.

The step of preparing rapidly solidified Aℓ-Si alloyed powder should preferably include the step of solidifying molten Aℓ alloy at the solidifying rate of at least 10²°C/sec.

Aℓ is disadvantageous in that it has extremely high coefficient of thermal expansion of 23.5 x 10⁻⁶/°C. On the other hand, Aℓ has density as small as 2.7g/cm³ and superior coefficient of thermal conductivity of 0.5cal/cm·sec·°C. Thus, Aℓ is preferable in view of density and thermal conductivity. However, the thermal conductivity is much degraded by solid solution or precipitation when it is turned to an alloy with other metal element.

Now, Si has coefficient of thermal conductivity of at least 0.3cal/cm·sec·°C, and degree of solid solution in Aℓ is relatively small. Therefore, when Si is added to Aℓ, Si crystallizes or is precipitated in Aℓ matrix as Si crystals, and therefore even when the content of Si increases, the coefficient of thermal conductivity of Aℓ-Si is relatively small. Further, Si has the coefficient of thermal expansion of 4.2 x 10⁻⁶/°C, and therefore when it is added to Aℓ, it enables lower coefficient of thermal expansion approximately in accordance with the rule of mixture.

As described above, Si is an element effective in reducing the coefficient of thermal expansion. However, when Si is added to the melt Aℓ alloy to be less than 10wt%, the effect of Si is too small to provide the desired property. If Si is added to the melt Aℓ alloy to be more than 50wt%, atomizing becomes difficult because of solution or solidification of Si. Therefore, desired amount of Si to be contained in the melt Aℓ alloy is from 10wt% to 50wt%.

Since the content of Si in melt Aℓ alloy is from 10wt% to 50wt%, the content of Si in the nitrogenous Aℓ-Si powder metallurgical alloy after nitriding approximately corresponds to 8.5wt% to 48wt%.

The size of the Si crystal crystallized or precipitated in Aℓ matrix largely depends on the rate of solidification. If this rate of solidification is less than 10²°C/sec, the crystallized Si crystal becomes too large, lowering moldability and cuttability. Therefore, the rate of solidification should preferably be at least 10²°C/sec.

The rate of solidification of air atomize is about 10³°C/sec, and rate of solidification of various atomized method is at least 10²°C/sec. When the rate of solidification is set to 10³°C/sec, the grain size of the primary Si crystal would be 40µm at the largest.

### [Relative Density of the Molded Body]

The step of compression molding should desirably include the step of compression molding in which the relative density of the molded body is set to be at least 50% and at most 90%.

In the control of nitriding, management of density of the molded body is of critical importance. In order to allow homogenous nitriding reaction in the molded body with the nitrogen in the atmosphere, air permeability of the molded body is important. In order to ensure sufficient air permeability, the relative density of the molded body should necessary be at most 90%. If the relative density is lower than 50%, strength of the molded body is too low. Therefore, the relative density should desirably be at least 50% and at most 90%.

As for the pressure for molding, when it exceeds 6t/cm², the surface layer portion becomes too dense, degrading air permeability. Therefore, in order to obtain the aforementioned relative density of the molded body, the pressure for molding should not be higher than 6t/cm².

### [Sintering Atmosphere]

Preferably, the step of sintering includes the step of sintering the molded body in a normal pressure atmosphere with the nitrogen partial pressure of at least 0.95atm. Here, the normal pressure refers to the normal pressure applied by the atmosphere gas to the molded body during sintering, which is not increased or reduced from the ambient pressure.

Preferably, the normal pressure atmosphere has steam partial pressure of at most 0.01atm.

In order to generate nitride on the surface of the powder during nitriding so as to promote sintering phenomenon, it is necessary to provide an atmosphere mainly consisting of nitrogen gas. For this purpose, it is preferred that the nitrogen partial pressure is at least 0.95atm.

Sintering can be promoted to some extent when the atmosphere pressure is increased. However, in view of cost efficiency and necessary equipments, normal pressure is sufficient.

If steam partial pressure in the atmosphere is too high, oxidation of Aℓ component at the surface of the powder proceeds, hindering nitriding. Further, steam serves to decompose the nitride formed on the surface of the powder. Therefore, it is necessary to reduce partial pressure of steam, further in view of assisting evaporation and decomposition of water absorbed in the powder while the temperature is increased to the sintering temperature. Therefore, it is desirable to suppress steam partial pressure to be at most 0.01atm.

### [Grain Size of the Powder and Specific Surface Area]

Preferably, the rapidly solidified Aℓ-Si alloyed powder should have the maximum grain diameter of 74µm, average grain diameter of at most 67µm, and specific surface area of at least 0.2m²/g.

When powder is to be prepared by atomizing, the rate of solidification differs dependent on the grain size of the powder. Further, frequency of metal contact between powders and surface area reacting with nitrogen are much influenced by the grain size of the powder. If the maximum grain diameter of the raw material powder exceeds 74µm, the average grain diameter exceeds 67µm or the specific surface area becomes smaller than 0.2m²/g, nitriding reaction becomes slower, and the distribution of nitride becomes uneven. Therefore, it is desirable to prepare powder having maximum grain diameter of 74µm, average grain diameter of at most 67µm and specific surface area of at least 0.2m²/g. Here, the specific surface refers to the surface area per unit weight.

### [Forging]

Preferably, the manufacturing method further includes the step of heating the sintered body obtained through the step of sintering to at least 400°C and molding and consolidating the sintered body by using a forging die of which temperature is at least 150°C with forging pressure of at least 4t/cm² so that the relative density is made at least 98%, thus providing a forging body.

The nitrided sintered body has pores inside, and therefore it has low thermal conductivity and air tightness. Therefore, when higher air tightness and strength are required with thermal conductivity increased, the sintered body may be caked by forging. If the relative density of the body obtained by forging exceeds 98%, thermal conductivity and air tightness are much improved. In order to attain such a high relative density, it is desired to soften the sintered body by heating the same to 400°C or more, and consolidating the same under the forging pressure of at least 4t/cm². At this time, if the temperature of the die is lower than 150°C, the surface layer of the sintered body cannot be made dense. Therefore, the die should preferably be heated to 150°C or more.

### [Sizing·Coining]

The nitrided sintered body has pores inside. Therefore, surface roughness and dimensional precision can be much improved by sizing or coining. The correcting pressure providing such effects is at least 4t/cm².

### [Hot Extrusion·Machining·Surface Treatment]

The sintered body obtained through the above described steps is actually used as it is or after further machining. A material such as AlN containing ceramics is often difficult to machine. However, in the nitrogenous Al-Si powder metallurgical alloy in accordance with the present invention, AlN is produced by reaction and it has very fine particles. Therefore, it allows cutting as well as threading.

A desired shape can be obtained by hot extrusion of the nitrided molded body.

After the aforementioned further machining, surface treatment may also be performed as needed. For example, if it is to be used as a semiconductor substrate or a package, a surface layer of metal such as Au or Ni or a surface layer of an insulator such as Al₂O₃, AlN or SiO₂ may be formed to improve wettability with solder or glass, or to ensure insulation. Since the nitrogenous Al-Si powder metallurgical alloy of the present invention is based on Al, the surface layer of Al₂O₃ can be naturally and readily formed by anodic oxidation, and a surface layer of AlN can be naturally and readily formed by nitriding, both layers to the sufficient thickness.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a block diagram showing steps of manufacturing in accordance with Embodiment 1 of the present invention.

Fig. 2 is a graph showing influence of grain size and density after molding on the amount of nitrogen in the nitrided body obtained in Embodiment 1 of the present invention.

Figs. 3A, 3B and 3C are graphs showing the influence of nitrogen content on the coefficient of thermal expansion, the coefficient of thermal conductivity and the density of the forging body obtained in Embodiment 1 of the present invention.

Fig. 4 is a graph showing influence of temperature and time of processing on the content of nitrogen in the nitrided body obtained in Embodiment 2 of the present invention.

Fig. 5 is a microphotograph of a texture of the nitrided body including Al and 38wt% of Si obtained in Embodiment 3 of the present invention.

Fig. 6 is an X-ray analysis image of the nitrided body of the powder molded body containing Al and 38wt% of Si obtained in Embodiment 3 of the present invention.

Fig. 7 is a graph showing influence of grain size and density after molding on nitrogen content of the nitrided body obtained in Embodiment 5 of the present invention.

Fig. 8 is a graph showing the influence of nitrogen content on the coefficient of thermal expansion of forging body obtained in Embodiment 5 of the present invention.

Fig. 9 is a graph showing the influence of nitrogen content on the coefficient of thermal conductivity of the forging body obtained in Embodiment 5 of the present invention.

Fig. 10 is a graph showing the influence of nitrogen content on the density of the forging body obtained in Embodiment 5 of the present invention.

Fig. 11 is a microphotograph of a texture of the forging body of the powder molded body containing Al-38wt% of Si and 1wt% of Mg obtained in Embodiment 6 of the present invention.

Fig. 12 is an X-ray analysis image of the forging body of the powder molded body containing Al-38wt% of Si and 1wt% of Mg obtained in Embodiment 6 of the present invention.

Fig. 13 is a graph showing the influence of temperature and time of nitriding on the amount of nitrogen in the nitrided body obtained in Embodiment 8 of the present invention.

Fig. 14 is a cross section schematically showing an IC package structure employing the nitrogenous Al-Si powder metallurgical alloy of the present invention.

Fig. 15 is a cross section schematically showing an IC package structure employing the nitrogenous Al-Si powder metallurgical alloy of the present invention.

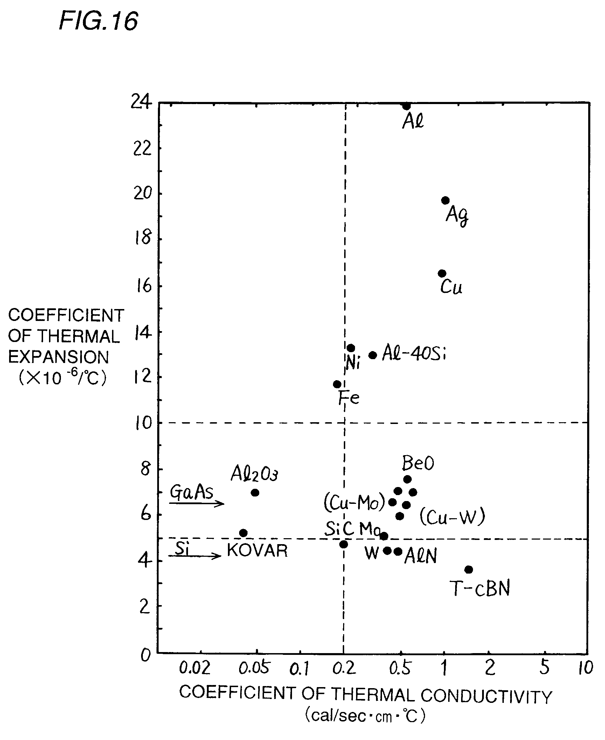

Fig. 16 shows relation of coefficients of thermal conductivity and coefficients of thermal expansion of various materials.

### DESCRIPTION OF THE PREFERRED EMBODIMENTS

### Embodiment 1

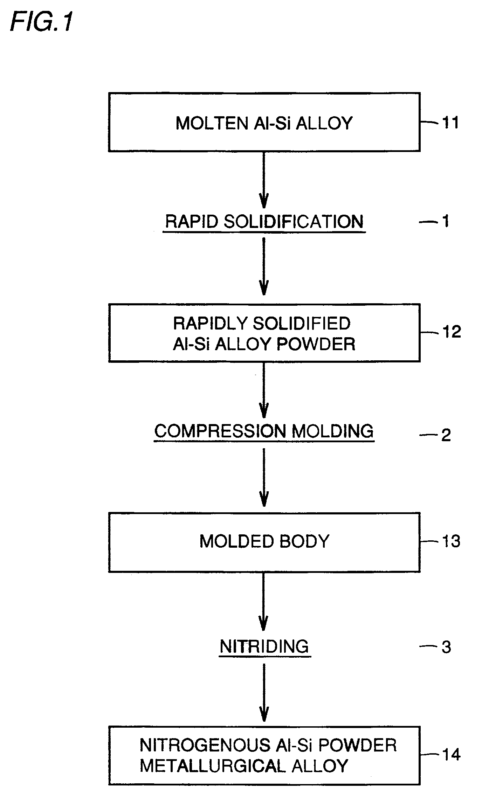

Referring to Fig. 1, molten Al-Si alloy 11 containing 41wt% of Si was rapidly solidified (step 1) at the solidifying rate of 10³°C/sec in accordance with air atomize method to provide powder. The as-obtained atomized powder 12 of rapidly solidified Al-Si alloy was sifted to 149-105µm (119µm), 105-74µm (88µm), 74-63µm (67µm), 63-44µm (52µm) and smaller than 44µm (31µm), where the values in the parenthesis denote average grain size.

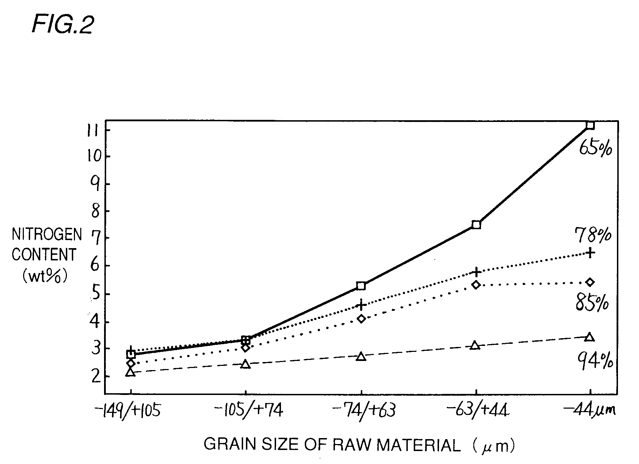

An acetone solution of myristic acid was applied to the dies, and respective powders 12 were molded into tablet specimens (molded bodies 13) of φ20x30mm with relative densities of 65%, 78%, 85% and 94% under molding pressure in the range of 2 to 10t/cm² (step 2). The molded bodies 13 were subjected to nitriding for 10 hours at 560°C in a normal pressure atmosphere, of which nitrogen partial pressure was at least 0.99atm and steam partial pressure was at most 0.005atm (step 3). The influence of the grain size and the density after molding on the nitrogen content in the nitrided body is as shown in Fig. 2.

Here, the molded body having relative density of lower than 50% could not retain its shape, as it was chipped off when taken out from the dies.

As is apparent from the results shown in Fig. 2, if the maximum grain size exceeds 74µm (average grain diameter of 67µm), content of nitrogen become smaller than 4wt% at every relative density.

When the true relative ratio 90%, the nitrogen content does not reach 4wt% even when the grain size of the atomized powder is reduced.

Here, the sign - denotes the maximum grain diameter and + denotes the minimum grain diameter.

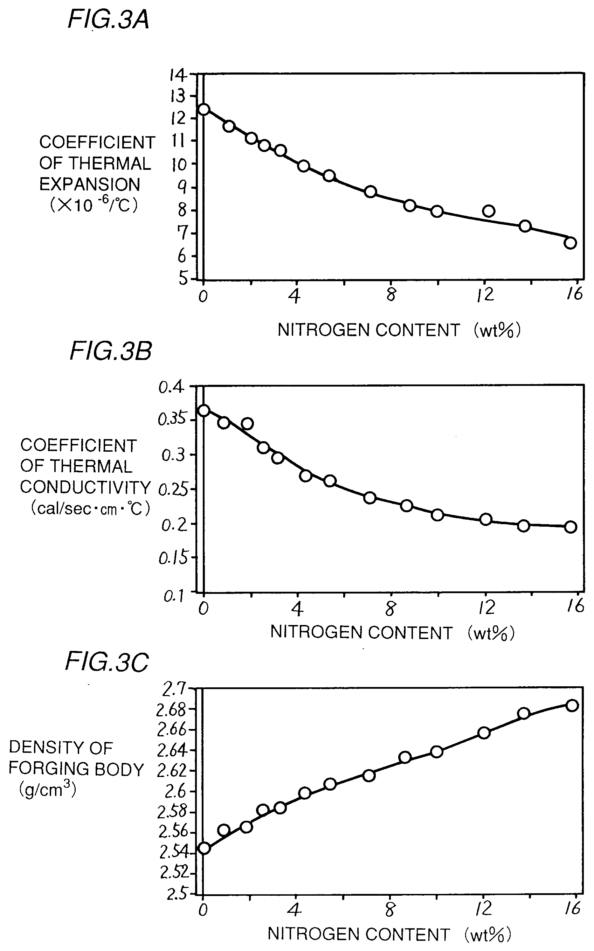

Then, powder having maximum grain diameter of 44µm and average grain diameter of 31µm was subjected to compression molding under the molding pressure of 2t/cm³ to have the relative density of 65%, and thus a molded body was obtained. The molded body was nitrided for 0 to 22 hours at the temperature of 560°C in a normal pressure atmosphere of which nitrogen partial pressure was at least 0.99atm and steam partial pressure was at most 0.05atm. The nitrided bodies were heated to 500°C, and then inserted to forging die of φ22mm of which die temperature was 350°C. Thereafter, the nitrided bodies were consolidated with the bearing of 6t/cm² by using the forging dies, thus fabricating forging bodies having relative densities of 98 to 100%. Figs. 3A, 3B and 3C show relations between nitrogen content and various properties (density, thermal conductivity and coefficient of thermal expansion) of the forging bodies.

The coefficient of thermal expansion was measured by push rod method, the value of which was an average value from 20°C to 200°C. The coefficient of thermal conductivity was measured in accordance with the laser flash method, and the density was measured in accordance with Archimedes's methods.

Referring to Fig. 3A, if nitrogen content is smaller than 4wt%, the coefficient of thermal expansion exceeds 10x10⁻⁶/°C.

Referring to Fig. 3B, if nitrogen content exceeds 15wt%, the coefficient of thermal conductivity becomes smaller than 0.2cal/cm·sec·°C.

Referring to Fig. 3C, the density of the forging body was not higher than 3.0g/cm³ at any nitrogen content measured.

As is apparent from Figs. 3A, 3B and 3C, the target property values can be attained when the nitrogen content is at least 4wt% and at most 15wt%.

From the result of X-ray analysis, it was found that no less than 90wt% of nitrogen contained in the forging body was AlN.

### Embodiment 2

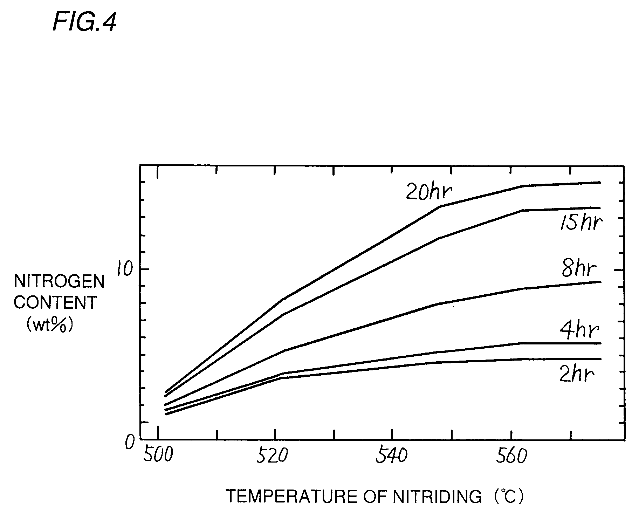

The powder prepared in Embodiment 1 was sifted so as to have the maximum grain diameter of at most 74µm, and Al-41wt% Si alloy powder having average grain diameter of 32µm was obtained. The powder was subjected to compression molding with the pressure of 2t/cm², and thus molded bodies having relative density of 66% and dimension of 10x10x15mm was prepared. In a normal pressure atmosphere with nitrogen partial pressure of at least 0.99atm and steam partial pressure of at most 0.005atm, the molded bodies were subjected to nitriding for 2 to 20 hours at 480°C, 501°C, 521°C, 548°C, 562°C and 575°C. Fig. 4 shows the influence of temperature and time of processing on the amount of nitrogen in the nitrided bodies.

Referring to Fig. 4, when nitriding is performed for 2 hours at a temperature lower than 530°C, the nitrogen content in the nitrided body becomes smaller than 4wt%. If nitriding is performed for more than 20 hours at 570°C, the nitrogen content of the nitrided body exceeds 15wt%. If the temperature of nitriding exceeds 570°C, the molded body becomes soft and deformed during nitriding. From the experimental results, it was found that the temperature for nitriding must be in the range of from 530°C to 570°C and the time for nitriding must be at least 2 hours and at most 20 hours, in order to attain the desired value of nitrogen content in the nitrided body.

In the above described experiment, the nitrided body which was subjected to nitriding for 8 hours at a temperature of 548°C was thereafter heated to 500°C and inserted to a forging die of 11x16mm which had been heated to 350°C. Thereafter, the nitrided body was consolidated with the bearing of 6t/cm² by using the forging die, and a forging body having the relative density of 100% was fabricated. The density of the forging body was 2.62g/cm³, the coefficient of thermal conductivity was 0.24cal/cm·sec·°C, and the coefficient of thermal expansion was 8.7x10⁻⁶/°C.

The molded body was nitrided for 8 hours at 540°C in a normal pressure atmosphere with nitrogen partial pressure of 0.90atm and steam partial pressure of 0.05atm. However, in that case, generation of a nitride was not observed.

### Embodiment 3

Molten Al-Si alloy containing 8wt%, 11wt%, 25wt%, 38wt%, 45wt% and 54wt% of Si, respectively, were powdered by air atomize method. The resulting powder was sifted so as to have the maximum gain diameter of at most 74µm. Thus Al-8wt% Si, Al-11wt% Si, Al-25wt% Si, Al-38wt% Si and Al-45wt% Si having average grain diameter of 32µm, were prepared.

Here, the molten alloy of Al-54wt% Si caused nozzle choking during air atomize, thus atomization was impossible. An acetone solution of myristic acid was applied to the dies, the respective powders were subjected to compression molding with the molding pressure of 2 to 2.5t/cm², and tablet specimens of φ20x30mm with relative density of about 70% were fabricated. The molded bodies were nitrided for 15 hours at 540°C in a normal pressure atmosphere, with nitrogen partial pressure being at least 0.99atm and steam partial pressure being at most 0.005atm. The nitrided bodies obtained in this manner were heated to 500°C, and inserted to forging dies of φ22mm which had been heated to 350°C, as in Embodiment 1. Thereafter, the nitrided bodies were consolidated with the bearing of 6t/cm² by using the forging dies, and forging bodies having relative densities of 98 to 100% were fabricated. The density, the coefficient of thermal expansion and the coefficient of thermal conductivity of the forging bodies were as shown in the table below.

**Table 1**

| Si Content in Powder (wt%) | | 8 | 11 | 25 | 38 | 45 |
|---|---|---|---|---|---|---|
| Properties of Nitrided Bodies | Nitrogen Content (wt%) | 11.8 | 12.2 | 12.5 | 11.2 | 10.3 |
| | Si Content (wt%) | 7.1 | 9.7 | 21.9 | 33.7 | 40.4 |
| | Density (g/cm³) | 2.84 | 2.83 | 2.76 | 2.67 | 2.62 |
| | Coefficient of Thermal Expansion (x10⁻⁶/°C) | 10.4 | 9.9 | 8.6 | 8.0 | 7.7 |
| | Coefficient of Thermal Conductivity (cal/cm·sec·°C) | 0.38 | 0.33 | 0.23 | 0.21 | 0.20 |

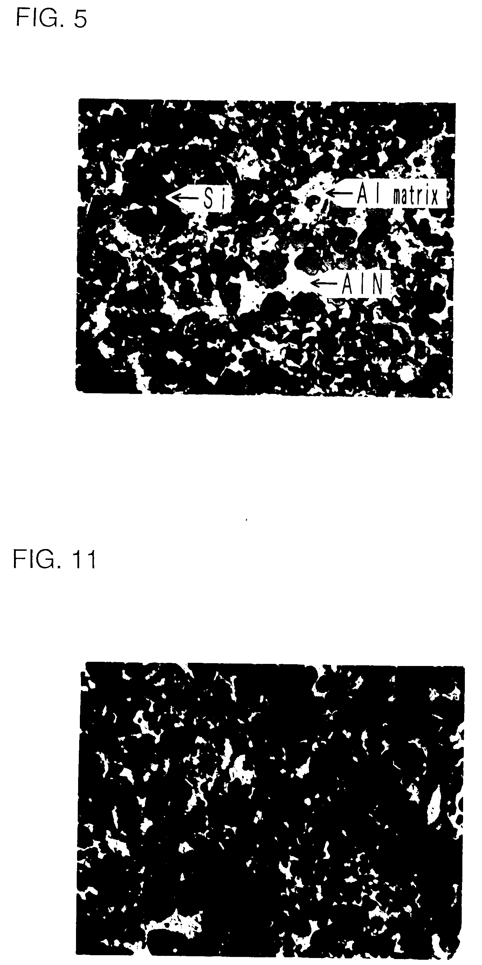

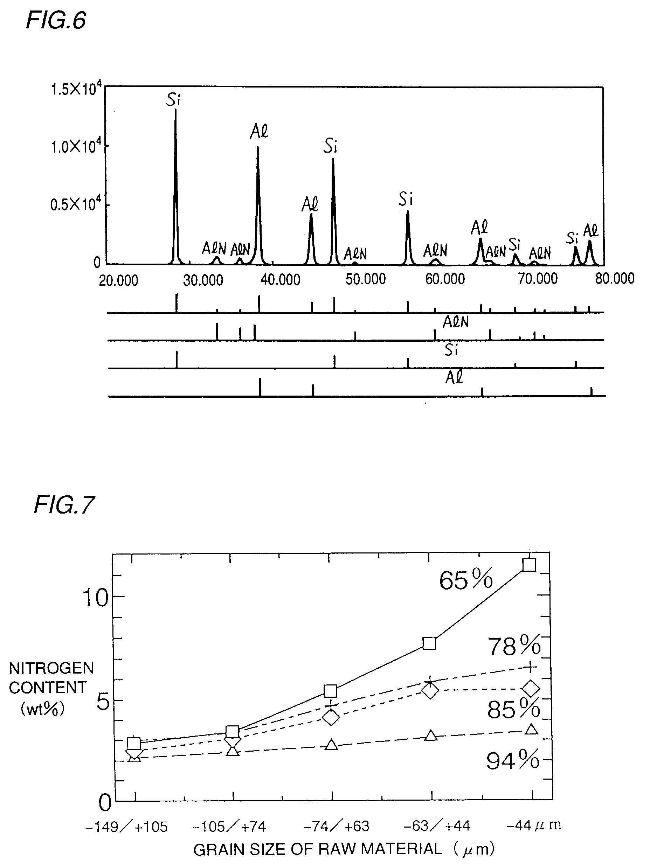

Fig. 5 is a microphotograph of the texture observed during forging of the powder molded body containing Al and 38wt% of Si. In the photograph of Fig. 5, relatively dark (black) portion corresponds to Si, white portion corresponds to Al matrix, and relatively bright (gray) portion corresponds to AlN. Fig. 6 is an X-ray analysis image of the nitrided body.

Mainly from the results shown in the table, it can be understood that the coefficient of thermal expansion of the nitrided body fabricated by using Al-8wt% Si powder exceeds 10x10⁻⁶/°C. Molten Al-54wt% Si could not be atomized. Therefore, it is understood that in order to obtain nitrided body having desired nitrogen content, molten Al alloy must contain at least 10wt% and at most 50wt% of Si.

### Embodiment 4

Molten Al-Si alloy containing 45wt% of Si was powdered by air atomize method. The powder was sifted so that it had maximum grain diameter of at most 74µm. Thus Al-45wt% Si having average grain diameter of 32µm was prepared.

An acetone solution of myristic acid was applied to the die, the powder is subjected to compression molding at the pressure of 2.5t/cm², and a tablet specimen having the dimension of φ98x50mm and relative density of about 70% was fabricated. The molded body was nitrided for 15 hours at a temperature of 540°C in a normal pressure atmosphere of which nitrogen partial pressure was at least 0.99atm and steam partial pressure was at most 0.005atm. The nitrogen content of the nitrided body obtained through this nitriding was measured, which was 10.5wt%, and the nitrogen content in AlN equivalent was 31wt%.

Meanwhile, commercially available AlN powder having average grain diameter of 0.8µm was added, to 31wt%, to Al-45wt% Si having average grain diameter of 32µm. Thereafter, an acetone solution of myristic acid was applied to the die, and the mixed powder was subjected to compression molding under the pressure of 2.5t/cm². Thus a tablet specimen having the dimension of φ98x50mm and relative density of about 70% was fabricated.

The nitrided body and the molded body of the powder to which AlN was added were both heated to 500°C, and inserted to forging dies of φ100mm of which temperature was 350°C. Thereafter, the nitrided bodies were consolidated with the bearing of 6t/cm² by using the forging dies.

The density, the coefficients of thermal conductivity and the coefficients of thermal expansion of these forging bodies were as shown in the table below.

**Table 2**

| | Nitrided Body | AlN Powder Added |
|---|---|---|
| Density (g/cm³) | 2.62 | 2.55 |
| Coefficient of Thermal Expansion (x 10⁻⁶/°C) | 7.7 | 7.9 |
| Coefficient of Thermal Conductivity (cal/cm·sec·°C) | 0.20 | 0.17 |

It can be seen from the table above that the forging body with AlN powder added has inferior hot moldability as compared with the nitrided body, and the density was reduced though it has the same composition. As a result, the forging body with AlN powder added came to have lower coefficient of thermal conductivity than the nitrided body.

Further, cutting was performed for both specimens. The nitrided body could be cut until a desired shape was obtained. By contrast, the forging body to which AlN powder was added was chipped because of dropping of AlN, which made cutting difficult. From these results, it is understood that the forging body of the present invention is far superior in cuttability as compared with the forging body to which AlN powder was added. The reason for this may be the fact that AlN in the forging body of the present invention was produced by reaction, so that particles are very fine and dispersed uniformly.

Further, respective forging bodies were cut to □30x20x5mm and heated for 10 minutes at 850°C. The forging body to which AlN powder was added expanded and cracked by the thermal processing, and it cannot retain the aforementioned shape. By contrast, the nitrided body was not deformed at all by this thermal processing. The reason for this may be that AlN was generated to coat Al having low melting point in the nitrided body, so that heat resistance thereof was improved.

### Embodiment 5

Referring to Fig. 1, molten Al-Si alloy 11 containing 41wt% of Si and 1wt% of Mg was rapidly solidified (step 1) at the solidification rate of 10³°C/sec by air atomize method, and thus the powder was obtained. The as-obtained atomized powder 12 of rapidly solidified Al-Si alloy was sifted to have the grain size of 149-105µm (119µm), 105-74µm (88µm), 74-63µm (67µm), 63-44µm (52µm), and 44µm (31µm) or smaller. Here, the numerals in the parenthesis represent the average grain diameter.

An acetone solution of myristic acid was applied to the dies, and atomized powders 12 were molded to tablet specimens (molded bodies 13) of φ20x30mm having relative densities of 65%, 78%, 85% and 94% with the pressure in the range of from 2 to 10t/cm² (step 2). The molded bodies 13 were nitrided for 5 hours at 560°C in a normal pressure atmosphere of which nitrogen partial pressure was at least 0.99atm and steam partial pressure was at most 0.005atm (step 3). Fig. 7 shows influence of grain size and density after molding on the nitrogen content in the nitrided body.

As is apparent from the results shown in Fig. 7, when the maximum grain diameter exceeds 74µm (average grain diameter of 67µm), the nitrogen content becomes smaller than 4wt% at every relative density.

If the relative density exceeds 90%, the content of nitrogen cannot reach 4wt% even when the grain diameter of the atomized powder is reduced.

The molded body having relative density of 50% or smaller could not retain its shape as it was chipped when taken out from the dies.

In Fig. 7, the sign - represents the maximum grain diameter and + represents the minimum grain diameter.

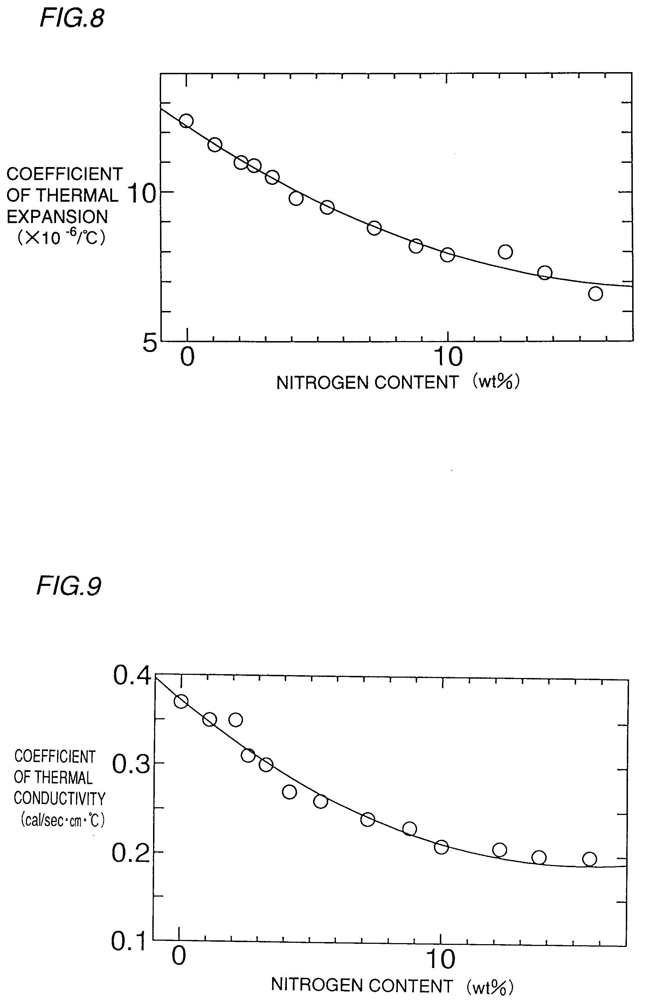

The aforementioned powder having the maximum grain diameter of 44µm and average grain diameter of 31µm was subjected to compression molding and a pressure of 2t/cm² to have relative density of 65%, and thus molded bodies were obtained. The molded bodies were nitrided for 0 to 9 hours at 560°C in a normal pressure atmosphere of which nitrogen partial pressure was at least 0.99atm and steam partial pressure was at most 0.005atm, so as to vary the nitrogen content. The resulting nitrided bodies were heated to 500°C and inserted to forging dies of φ22mm which had been heated to 350°C. Then, the nitrided bodies were consolidated with the bearing of 6t/cm² by using the forging dies, and forging bodies having relative densities of from 98 to 100% were fabricated. The relation between nitrogen content and coefficient of thermal expansion, coefficient of thermal conductivity and density of the forging bodies are shown in Figs. 8, 9 and 10.

The coefficient of thermal expansion was measured in accordance with the push rod method, and the value was an average of 20°C to 200°C. The coefficient of thermal conductivity was measured in accordance with the laser flash method, and the density was measured in accordance with the Archimedes's methods.

Referring to Fig. 8, when content of nitrogen is smaller than 4wt%, the coefficient of thermal expansion exceeds 10x10⁻⁶/°C.

Referring to Fig. 9, when the content of nitrogen exceeds 15wt%, the coefficient of thermal conductivity becomes smaller than 0.2cal/cm·sec·°C.

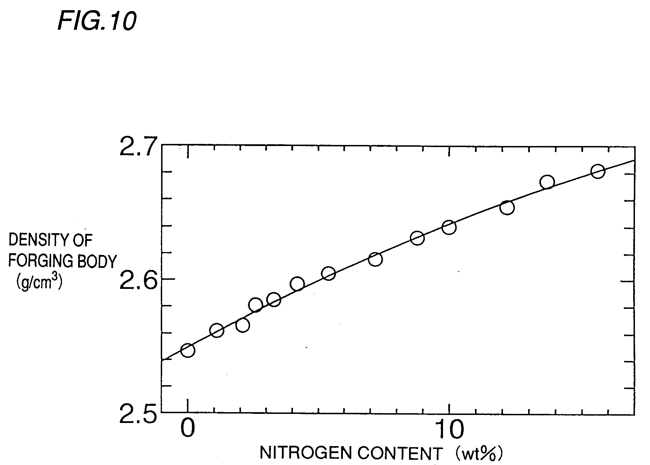

Referring to Fig. 10, the density of the forging bodies were not higher than 3.0g/cm³ at every measured nitrogen content.

As is apparent from Figs. 8, 9 and 10, the target property values can be attained when the nitrogen content is at least 4wt% and at most 15wt%.

From the result of X-ray analysis intensity, it was found that at least 90wt% of nitrogen contained in the forging bodies was AlN.

The molded bodies were nitrided for 8 hours at 540°C in a normal pressure atmosphere with nitrogen partial pressure of 0.90atm and steam partial pressure of at least 0.05atm. However, generation of a nitrogenous substance was not observed.

### Embodiment 6

Molten Al-Si alloy containing 8wt%, 11wt%, 25wt%, 38wt%, 45wt% and 54wt% of Si and 1wt% of Mg was powdered by air atomize method. The powder was sifted so as to have the maximum grain diameter of at most 74µm. Thus Al-8wt% Si-1wt% Mg, Al-11wt% Si-1wt% Mg, Al-25wt% Si-1wt% Mg, Al-38wt% Si-1wt% Mg and Al-45wt% Si-1wt% Mg, each having average grain diameter of 32µm were prepared.

The molten alloy of Al-54wt% Si-1wt% Mg could not be atomized as it caused nozzle choking during air atomizing.

An acetone solution of myristic acid was applied to the dies, respective powders were subjected to compression molding under the pressure of from 2 to 2.5t/cm², and tablet specimens of φ20x30mm having relative density of about 70% were fabricated. The molded bodies were nitrided for 8 hours at 540°C in a normal pressure atmosphere with nitrogen partial pressure of at least 0.99atm and steam partial pressure of 0.005atm at most. The as-obtained nitrided bodies were heated to 500°C and inserted to forging dies of φ22mm which were heated to 350°C. Thereafter, the nitrided bodies were consolidated with the bearing of 6t/cm² using the forging dies, and forging bodies having relative densities of from 98 to 100% were fabricated. Densities, coefficients of thermal expansion and coefficients of thermal conductivity were as shown in the table below.

**Table 3**

| Si Content in Powder (wt%) | | 8 | 11 | 25 | 38 | 45 |
|---|---|---|---|---|---|---|
| Properties of Nitrided Bodies | Nitrogen Content (wt%) | 11.8 | 12.2 | 12.5 | 11.2 | 10.3 |
| | Si Content (wt%) | 7.1 | 9.7 | 21.9 | 33.7 | 40.4 |
| | Density (g/cm³) | 2.84 | 2.83 | 2.76 | 2.67 | 2.62 |
| | Coefficient of Thermal Expansion (x10⁻⁶/°C) | 10.4 | 9.9 | 8.6 | 8.0 | 7.7 |
| | Coefficient of Thermal Conductivity (cal/cm·sec·°C) | 0.38 | 0.33 | 0.23 | 0.21 | 0.20 |

Mainly from the results shown in the table, it can be understood that the coefficient of thermal expansion of the forging body fabricated by using Al-8wt% Si-1wt% Mg powder exceeds 10x10⁻⁶/°C. The molten alloy of Al-54wt% Si-1wt% Mg could not be atomized. Therefore, it can be understood that in order to obtain a nitrided body having desired nitrogen content, the molten Al alloy must contain at least 10wt% and at most 50wt% of Si.

A microphotograph of texture observed in the forging body of Al-38wt% Si-1wt% Mg powder molded body is shown in Fig. 11. In the photograph of Fig. 11, the block portion corresponds to Si, the white portion corresponds to Al matrix and the gray portion corresponds to AlN. Fig. 12 is an X-ray analysis image of the forging body.

### Embodiment 7

Molten Al-Si alloys, to which Si was added to 33wt% and elements shown in the table below were mixed, were powdered by air atomize method. The powders were sifted to have the maximum grain diameter of at most 74µm.

An acetone solution of myristic acid was added to dies, and respective powders are subjected to compression molding with the pressure of from 2 to 2.5t/cm², and tablet specimens of φ20x30mm having relative density of about 70% were fabricated. The molded bodies were nitrided for 8 hours at 540°C in a normal pressure atmosphere with nitrogen partial pressure of at least 0.99atm and steam partial pressure of at most 0.005atm. The as-obtained nitrided bodies were heated to 500°C, and then inserted to forging dies of φ22mm which were heated to 350°C. Thereafter, the nitrided bodies were consolidated with the bearing of 6t/cm² using the forging dies, and forging bodies having relative densities of from 98 to 100% were fabricated. The densities, coefficients of thermal expansion and coefficients of thermal conductivity of the forging bodies were as shown in the table below.

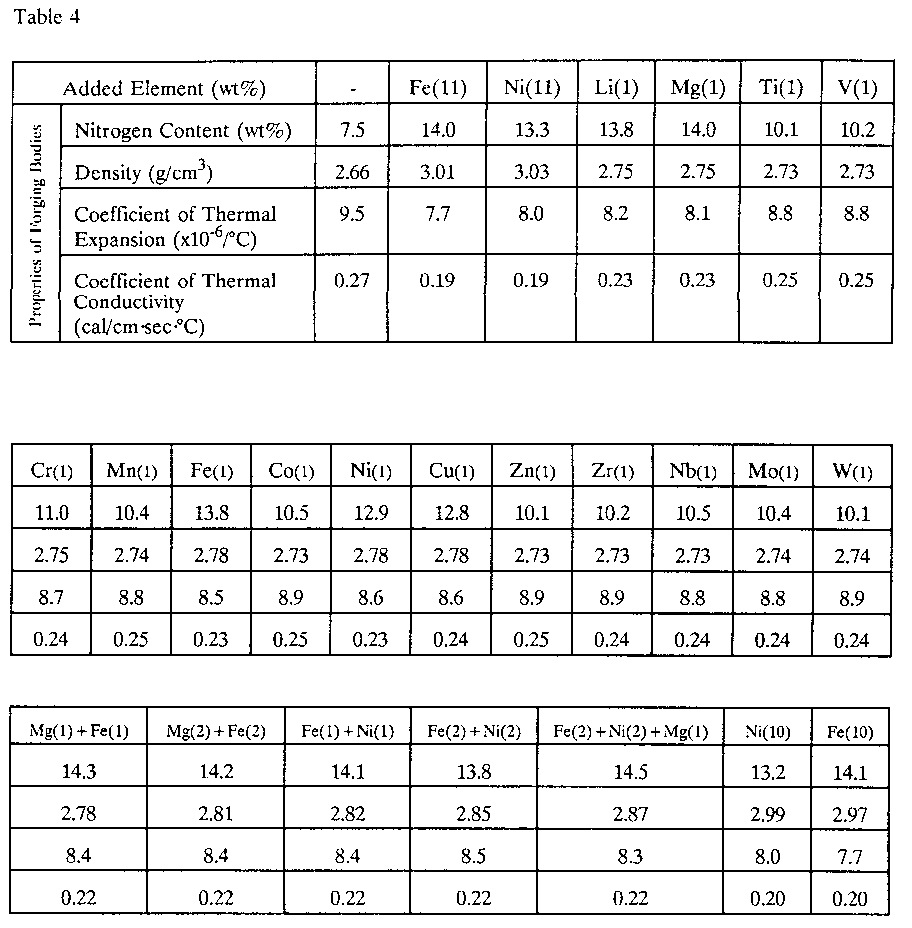

From the results shown in the table above, it can be understood that nitriding is promoted by addition of any of the listed elements. It can be seen that among these elements, addition of Li, Mg, Fe, Ni, Cu or combination thereof increases nitrogen content, and rate of nitriding is accelerated.

The target low density of at most 3.0g/cm³, high thermal conductivity of 0.2cal/cm·sec·°C and coefficient of thermal expansion of 5x10⁻⁶ to 10x10⁻⁶/°C can be obtained when the amount of added element is at most 10wt%. By contrast, if the added element exceeds 10wt%, the aforementioned properties cannot be satisfied.

The numerals in the parenthesis beside the added elements in the table denote wt% of added element in the rapidly solidified powder.

### Embodiment 8

The powder having the composition of Al-33wt% Si-2wt% Fe-2wt% Ni-1wt% Mg which has the highest nitrogen content among the powders fabricated in embodiment 7 was sifted to have the maximum grain diameter of at most 74µm, and alloy powder having average grain diameter of 32µm was obtained. The powder was subjected to compression molding under the pressure of 2t/cm², and a molded body having the relative density of 66% and the dimension of 10x10x15mm was obtained. The molded bodies were nitrided for 2 to 20 hours at 450°C, 470°C, 501°C, 521°C, 548°C, 562°C and 575°C, in a normal pressure atmosphere with nitrogen partial pressure of at least 0.99atm and steam partial pressure of at most 0.005atm. Fig. 13 shows influence of temperature and time of processing on the content of nitrogen in the nitrided bodies.

Referring to Fig. 13, when nitriding is performed for 2 hours at a temperature lower than 475°C, the content of nitrogen in the nitrided body becomes smaller than 4wt%. If the temperature for nitriding exceeds 570°C, the molded body became soft and deformed during nitriding. When the temperature of nitriding is 570°C and nitriding is performed for more than 8 hours, the content of nitrogen in the nitrided body exceeds 15wt%.

From the result of experiment, it was found that nitriding process must be performed for at least 2 hours and at most 8 hours at a temperature of from 475°C to 570°C in order to attain the desired nitrogen content in the nitrided body. It can be also understood that a nitrided body having desired nitrogen content can be obtained when the temperature for nitriding is set relatively low, provided that the time for nitriding does not exceed 20 hours.

### Embodiment 9

In the similar manner as in Embodiment 8, powder having the composition of Al-33wt% Si-2wt% Fe-2wt% Ni-1wt% Mg was sifted so as to have the maximum grain diameter of at most 74µm, and alloy powder having average grain diameter of 32µm was obtained. The powder was subjected to compression molding with the pressure of 2t/cm², and a molded body having relative density of 66% and the dimension of φ98x50mm was fabricated. The molded body was nitrided for 4 hours at 540°C in a normal pressure atmosphere with nitrogen partial pressure of at least 0.99atm and steam partial pressure of at most 0.005atm, so that the nitrogen content becomes 10.8wt%. The nitrogen content in AlN equivalent was 31.6wt%.

Meanwhile, commercially available AlN powder having average grain diameter of 0.8µm was mixed to 31.6wt% in the aforementioned Al-33wt% Si-2wt% Fe 2wt% Ni-1wt% Mg having average grain diameter of 32µm. Thereafter, an acetone solution of myristic acid was applied to the dies, respective powders were compression-molded with the pressure of 2.1t/cm², and tablet specimens having relative density of about 70% and dimension of φ98x50mm were fabricated. The nitrided body and the molded body to which AlN powder was mixed were respectively heated to 500°C, and then inserted to forging dies of φ100mm which had been heated to 350°C. Thereafter, the nitrided body and molded body were consolidated with the bearing of 6t/cm², using the forging dies. The relation between density, coefficients of thermal conductivity and coefficients of thermal expansion of the forging bodies were as shown in the table below.

**Table 5**

| | Nitrided Body | AlN Powder Added |
|---|---|---|
| Density (g/cm³) | 2.86 | 2.78 |
| Coefficient of Thermal Expansion (x10⁻⁶/°C) | 7.9 | 8.1 |
| Coefficient of Thermal Conductivity (cal/cm·sec·°C) | 0.24 | 0.18 |

It can be understood from the table that the forging body manufactured by adding AlN powder has inferior hot moldability as compared with the nitrided body and the density was also degraded though it has the same composition. As a result, the coefficient of thermal conductivity was degraded as compared with the nitrided body, to be lower than 0.2cal/cm·sec·°C.

Further, respective forging bodies were cut. The nitrided body could be cut to the target shape. However, cutting of the forging body to which AlN powder was added was difficult, since it was chipped because of dropping of AlN. It is apparent that the nitrided body of the present invention has superior cuttability. The reason for this may be the fact that in the present invention, AlN was produced by reaction, so that the particles are very fine and dispersed uniformly.

Further, it was found that in the nitrided body having this composition, amount of tool wear is very small. This may be the effect of addition of Fe and Ni which prevents movement of Si particles, and the effect of the addition of Mg which makes shorter the time for nitriding, both suppressing grain growth of Si.

Further, the forging bodies were cut to the shape of □30x20x5mm and heated for 10 minutes at 850°C. The forging body to which AlN powder was added could not retain its shape because of expansion and cracks. By contrast, the nitrided body was not deformed at all. The reason for this may be the superior heat resistance provided by the generation of AlN so as to coat Al having low melting point.

### Embodiment 10

An example in which the nitrogenous Al-Si powder metallurgical alloy of the present invention is used for an IC (Integrated Circuit) package will be described.

In this example, two nitrogenous Al-Si alloys with and without the aforementioned element(s) added were used for the IC package. The two different nitrogenous Al-Si alloys were prepared by the following methods 〈1〉 and 〈2〉.
〈1〉 Molten Al-Si alloy containing 45wt% of Si was powdered by air atomize method. The powder was sifted so as to have the maximum grain diameter of at most 74µm. In this manner, Al-45wt% Si having average grain diameter of 32µm was prepared. Thereafter, an acetone solution of myristic acid was applied to the die, the powder was compression-molded with the pressure of 2.5t/cm², and a tablet specimen having the dimension of φ98x50mm and relative density of about 70% was fabricated.
   The molded body was nitrided for 8 hours at 540°C in a normal pressure atmosphere with nitrogen partial pressure of at least 0.99atm and steam partial pressure of at most 0.005atm. The content of nitrogen in the nitrided body was measured, which was 7.5wt%, and 22wt% in AlN equivalent. The nitrided body was heated to 500°C, and inserted to a forging die of φ100mm which had been heated to 350°C. Thereafter, the nitrided body was consolidated with the bearing of 6t/cm² using the forging die, and a forging body having relative density of 100% was fabricated.
   The property values of the forging body were as follows. The density was 2.60g/cm³, the coefficient of thermal expansion was 8.2x10⁻⁶/°C, and the coefficient of thermal expansion was 0.24cal/cm·sec·°C. The forging body was cut to a desired shape.
〈2〉 The nitrogenous Al-Si alloy with the element(s) added were that having the composition of Al-33wt% Si-2wt% Fe-2wt% Ni-1wt% Mg fabricated in Embodiment 9 above. The forging body was cut to the desired shape.

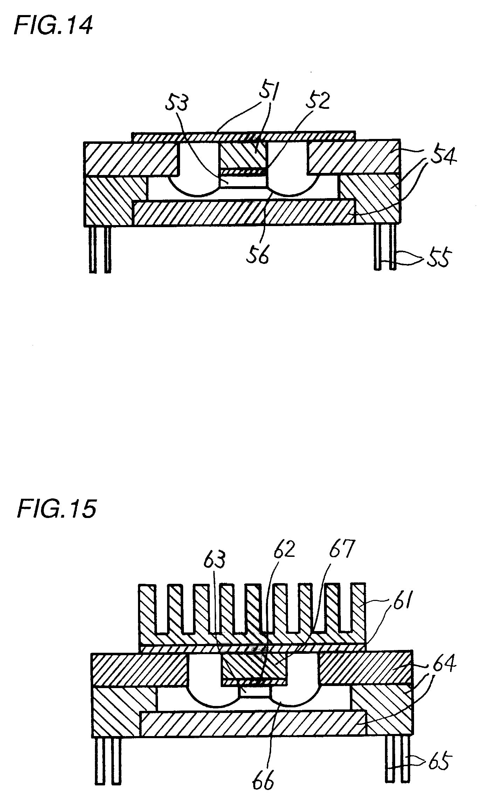

   Figs. 14 and 15 are cross sections schematically showing the structures of the nitrogenous Al-Si alloy of the present invention used for the IC package. First, referring to Fig. 14, the IC package includes a substrate 51, a solder 52, a semiconductor chip 53, an enclosure 54, a lead out electrode 55 and a bonding wire 56. On a top surface of enclosure 54 of ceramics such as alumina, substrate 51 is mounted. Substrate 51 is formed of the forging body processed in accordance with the above described method, which was further subjected to anodic oxidation. At a lower portion in the figure of substrate 51, a semiconductor chip 53 is bonded by means of solder 52. One end of bonding wire 56 is connected to a pad portion (not shown) of semiconductor chip 53, and the other end of bonding wire 56 is connected to a terminal (not shown) formed on the enclosure 54. This terminal is electrically connected to lead out terminal 55 of covar wire.

Referring to Fig. 15, the IC package can be distinguished from that of Fig. 14 especially by the substrates 61 and 67. More specifically, substrate 61 attached to the top surface of enclosure 64 has a fin-like shape so as to promote cooling, and it is formed of the forging body machining in accordance with the above described method. The substrate 61 is plated with Ni. The substrate 67 positioned between substrate 61 and semiconductor chip 63 (solder 62) is formed, for example, of copper (Cu) - tungsten (W) alloy. For bonding substrates 61 and 67 with each other, brazing (which requires operational temperature of 800°C), which was not available for an alloy containing Al, was employed. Except this points, the IC package of this figure is similar to that of Fig. 14, and therefore detailed description thereof is not repeated.

As shown in Figs. 14 and 15, the materials prepared in the manner described in 〈1〉 and 〈2〉 used for the substrates 51 and 62 in the present embodiment have coefficients of thermal expansion which are close to that of alumina (Al₂O₃) which is the material of the enclosure 54 or 64, and that of silicon which is the main material of the semiconductor chip 63. Therefore, strain derived from thermal stress is hardly generated during the steps of IC mounting. Since substrates 51 and 61 have superior heat radiation, the IC packages have long life and are highly reliable.

Heat-resistance test for 15 minutes at 200°C and heat cycle test of 100 cycles in the temperature range of -60°C to 150°C were performed on these two semiconductor elements and malfunction was not observed at all.

The substrate 61 shown in Fig. 15 having a number of fins for cooling could be manufactured by pressure-molding the material with or without the element(s) added with the pressure of 2.5t/cm², nitriding for 4 hours at 540°C in a normal pressure atmosphere with nitrogen partial pressure of at least 0.99atm and steam partial pressure of at most 0.005atm, filling the same in an aluminum container and hot-extruding the same at a temperature of 450°C.

From the foregoing, it was found that the nitrogenous Al-Si powder metallurgical alloy containing at least 4wt% and at most 15wt% of nitrogen and the remaining part substantially consisting of Al, Si and unavoidable component satisfies the conditions that it has the density of at most 3.0g/cm³, coefficient of thermal expansion of from 5x10⁻⁶ to 10x10⁻⁶/°C, and coefficient of thermal conductivity of at least 0.2cal/cm·sec·°C. By the nitrogenous Al-Si powder metallurgical alloy, a material suitable for a heat sink, a semiconductor substrate, a radiation substrate, housing and the like which is light and has low coefficient of thermal expansion and high coefficient of thermal conductivity could be obtained.

Further, it was found that the nitrogenous Al-Si powder alloy containing at least 4wt% to at most 15wt% of nitrogen, at least 8.5wt% and at most 48wt% of silicon, at most 9.6wt% of at least one element selected from the group consisting of Li, Mg, Ti, V, Cr, Mn, Fe, Co, Ni, Cu, Zn, Zr, Nb, Mo and W, and a remaining part essentially consisting of Al and unavoidable component satisfies the conditions that it has the density of at most 3.0g/cm³, coefficient of thermal expansion of from 5x10⁻⁶ to 10x10⁻⁶/°C and coefficient of thermal conductivity of at least 0.2cal/cm·sec·°C. By using the nitrogenous Al-Si powder metallurgical alloy, a material suitable for a heat sink, a semiconductor substrate, a heat radiating substrate, a housing and the like which is light and has low coefficient of thermal expansion and high coefficient of thermal conductivity could be obtained.

Since at least one element selected from the group consisting of Li, Mg, Ti, V, Cr, Mn, Fe, Co, Ni, Cu, Zn, Zr, Nb, Mo and W is added to the alloyed powder, nitriding can be performed at a relatively low temperature in relatively short period of time, when a molded body of the alloyed powder is nitrided to obtain powder metallurgical alloy having desired nitrogen content. Therefore, grain growth of the powder metallurgical alloy can be suppressed and the time necessary for the process can be reduced.

Although the present invention has been described and illustrated in detail, it is clearly understood that the same is by way of illustration and example only and is not to be taken by way of limitation, the spirit and scope of the present invention being limited only by the terms of the appended claims.

## Claims

1. A nitrogenous aluminum-silicon powder metallurgical alloy containing at least 4wt% and at most 15wt% of nitrogen, wherein remaining part consists essentially of aluminum, silicon and an unavoidable component.

2. The nitrogenous aluminum-silicon powder metallurgical alloy according to claim 1, having a nitride, at least 90wt% of said nitride consisting of AlN.

3. The nitrogenous aluminum-silicon powder metallurgical alloy according to claim 1, wherein
said silicon is contained at least 8.5wt% and at most 48wt%.

4. The nitrogenous aluminum-silicon powder metallurgical alloy according to claim 1, having at least one element selected from the group consisting of Li, Mg, Ti, V, Cr, Mn, Fe, Co, Ni, Cu, Zn, Zr, Nb, Mo and W added thereto, content of said added element being at most 9.6wt%.

5. A nitrogenous aluminum-silicon powder metallurgical alloy containing at least 4wt% and at most 15wt% of nitrogen, at least 8.5wt% and at most 48wt% of silicon, at most 9.6wt% of an element selected from the group consisting of Li, Mg, Ti, V, Cr, Mn, Fe, Co, Ni, Cu, Zn, Zr, Nb, Mo and W added thereto, wherein remaining part essentially consists of aluminum and an unavoidable component.

6. The nitrogenous aluminum-silicon powder metallurgical alloy according to claim 5, having a nitride, at least 90wt% of said nitride consisting of AlN.

7. A method of manufacturing a nitrogenous aluminum aluminum-silicon powder metallurgical alloy, comprising the steps of:
forming a rapidly solidified aluminum-silicon alloyed powder (12) by solidifying molten aluminum alloy (11) containing silicon (step 1);
obtaining a molded body (13) by compression-molding said rapidly solidified aluminum-silicon alloyed powder (step 2); and
sintering said molded body for at least 2 hours and at most 20 hours at a temperature in a range of from 530°C to 570°C in an atmosphere including nitrogen (step 3).

8. The method of manufacturing a nitrogenous aluminum-silicon powder metallurgical alloy according to claim 7, wherein
said molten aluminum alloy (11) is prepared to contain at least 10wt% and at most 50wt% of said silicon.

9. The method of manufacturing the nitrogenous aluminum-silicon powder metallurgical alloy according to claim 7, wherein
said step (step 1) of forming said rapidly solidified aluminum-silicon alloyed powder (12) includes the step of solidifying said molten aluminum alloy at a solidification rate of at least 10²°C/sec.

10. The method of manufacturing the nitrogenous aluminum-silicon powder metallurgical alloy according to claim 7, wherein
said step (step 2) of compression-molding includes the step of compression-molding so that relative density of said molded body (13) becomes at least 50% and at most 90%.

11. The method of manufacturing a nitrogenous aluminum-silicon powder metallurgical alloy according to claim 7, wherein
said step (step 3) of sintering includes the step of sintering said molded body (13) in a normal pressure atmosphere with nitrogen partial pressure of at least 0.95atm.

12. The method of manufacturing a nitrogenous aluminum-silicon powder metallurgical alloy according to claim 11, wherein
said normal pressure atmosphere has steam partial pressure of at most 0.01atm.

13. The method of manufacturing a nitrogenous aluminum-silicon powder metallurgical alloy according to claim 7, wherein
said rapidly solidified aluminum-silicon alloyed powder (12) has maximum grain diameter of at most 74µm, average grain diameter of at most 67µm and specific surface of at least 0.2m²/g.

14. The method of manufacturing a nitrogenous aluminum-silicon powder metallurgical alloy according to claim 7, further comprising the step of
obtaining a forging body by molding and consolidating the body, obtained by heating the sintered body resulting from said step of sintering (step 3) to at least 400°C, by using a forging die of which temperature is at least 150°C with forging pressure of at least 4t/cm² so that it has relative density of at least 98%.

15. The method of manufacturing a nitrogenous aluminum-silicon powder metallurgical alloy comprising the steps of:
forming a rapidly solidified aluminum-silicon alloyed powder (12) by solidifying a molten aluminum alloy (11) containing silicon and at least one element selected from the group consisting of Li, Mg, Ti, V, Cr, Mn, Fe, Co, Ni, Cu, Zn, Zr, Nb, Mo and W;
obtaining a molded body (13) by compression-molding said rapidly solidified aluminum-silicon alloyed powder (step 2); and
sintering said molded body for at least 2 hours and at most 8 hours in a temperature range of from 475°C to 570°C in an atmosphere containing nitrogen (step 3).

16. The method of manufacturing a nitrogenous aluminum-silicon powder metallurgical alloy according to claim 15, wherein
said molten aluminum alloy (11) is prepared to contain at least 10wt% and at most 50wt% of said silicon.

17. The method of manufacturing a nitrogenous aluminum-silicon powder metallurgical alloy according to claim 15, wherein
said molten aluminum alloy (11) is prepared to contain at most 10wt% of said element added.

18. The method of manufacturing a nitrogenous aluminum-silicon powder metallurgical alloy according to claim 15, wherein
said step (step 1) of forming said rapidly solidified aluminum-silicon alloyed powder (12) includes the step of solidifying said molten aluminum alloy at a solidification rate of at least 10²°C/sec.

19. The method of manufacturing a nitrogenous aluminum-silicon powder metallurgical alloy according to claim 15, wherein
said step (step 2) of compression-molding includes the step of compression-molding so that relative density of said molded body (13) becomes at least 50% and at most 90%.

20. The method of manufacturing a nitrogenous aluminum-silicon powder metallurgical alloy according to claim 15, wherein
said step (step 3) of sintering includes the step of sintering said molded body (13) in a normal pressure atmosphere with nitrogen partial pressure of at least 0.95atm.

21. The method of manufacturing a nitrogenous aluminum-silicon powder metallurgical alloy according to claim 20, wherein
said normal pressure atmosphere has steam partial pressure of at most 0.01atm.

22. The method of manufacturing a nitrogenous aluminum-silicon powder metallurgical alloy according to claim 15, wherein
said rapidly solidified aluminum-silicon alloyed powder (12) has maximum grain diameter of at most 74µm, average grain diameter of at most 67µm and specific surface of at least 0.2m²/g.

23. The method of manufacturing a nitrogenous aluminum-silicon powder metallurgical alloy according to claim 15, further comprising the step of
obtaining a forging body by molding and consolidating the body, obtained by heating the sintered body resulting from said step of sintering (step 3) to at least 400°C, by using a forging die of which temperature is at least 150°C with forging pressure of at least 4t/cm² so that it has relative density of at least 98%.
